# EUROPEAN PATENT APPLICATION

(11) **EP 4 550 405 A1**
(43) Date of publication of application: **07.05.2025**
(21) Application number: 23207649.7
(22) Date of filing: 03.11.2023
(51) Int. Cl.: H01L 23/367, H01L 23/482, H01L 29/06, H01L 29/778, H01L 29/423, H01L 29/737, H01L 29/417, H01L 29/205

(54) **A SEMICONDUCTOR PROCESSING METHOD AND A SEMICONDUCTOR COMPONENT OBTAINABLE BY APPLYING THE METHOD**

(71) Applicant: Imec VZW, 3001 Leuven (BE)
(72) Inventor: Yadav, Sachin, 3001 Leuven (BE); Kunert, Bernardette, 3012 Wilsele (BE); Parvais, Bertrand, 1457 Nil-Saint-Vincent (BE); Vermeersch, Bjorn, 3001 Leuven (BE); Vais, Abhitosh, 3001 Leuven (BE); Boccardi, Guillaume, 3001 Leuven (BE); Kumar, Annie, 3001 Leuven (BE)
(74) Representative: Patent Department IMEC

(57) **Abstract**

An isolated mesa structure (2) is produced on a semiconductor substrate (1), with active layers (5,6;36-39) of a semiconductor device integrated in an upper portion of the mesa structure (2). One or more openings (15,45,55,70) are formed in the dielectric material (11,25,27,43) that is isolating the mesa structure (2) on the lateral sides thereof, and a bottom portion of the mesa structure and/or a portion of the dielectric material directly adjacent said bottom portion of the mesa structure is removed. A cavity (16,46,59) is thereby formed that is subsequently filled with a material of high thermal conductivity, thereby creating a thermally conductive volume (17,47,61) configured to remove heat from the device to the substrate.. The invention is also related to a semiconductor component obtainable by applying the method according to the invention.

## Description

### Field of the Invention

The present invention is related to production processes for the fabrication of semiconductor devices. The invention is particularly useful for the production of high-power compound semiconductor devices such as HBTs (Heterojunction Bipolar Transistor) and III-V based HEMTs (High Electron Mobility Transistor).

### State of the art

III-V devices fabricated with materials such as InP and GaAs are key devices for RF and mmWave wireless communications. In a radio frequency (RF) or millimetre Wave (mmWave) transceiver front end module (FEM), III-V HBTs are used to implement power amplifiers and III-V HEMTs are used for either power or low-noise amplifiers. One key challenge hindering power device performance is the high junction temperatures at which these devices operate. In addition to device instantaneous performance, a high junction temperature is detrimental for device reliability. Many research groups have attempted to reduce the operating junction temperature in power devices. These include device front and back-end as well as packaging level solutions. Device front-end solutions include replacing thermally resistive material layers with more thermally conductive ones. In the back-end processing, the solutions include using heat spreading dielectric layers e.g. diamond layers, and metal thermal shunts.

Another solution is achieved through wafer bonding where the device is transferred to a high thermal conductivity substrate. For example, document "InP HBT substrate transferred to higher thermal conductivity substrate", Dennis W Scott et al, IEEE EDL, Vol. 33, No. 4. 2012, describes a method wherein HBTs are transferred to a high thermal conductivity SiC substrate. In this approach the output terminal (usually collector in case of HBTs) is in contact with the high conductivity substrate which improves the heat flow as compared to a monolithic approach wherein the transistor is built on a semiconductor substrate. However, the wafer transfer process creates additional process complexity, as additional device processing must be done post transfer (such as emitter patterning) in addition to the layer transfer itself.

It is desirable therefore to produce HBTs and III-V HEMTs by a monolithic approach, i.e. by fabricating the devices on a base substrate and without applying wafer transfer, while at the same time increasing significantly the thermal conductivity from the device towards the base substrate.

### Summary of the invention

The invention is related to methods and to semiconductor components in accordance with the appended claims. According to the method of the invention, a laterally isolated mesa structure is produced on a semiconductor substrate, with active layers of a semiconductor device integrated in an upper portion of the mesa structure. One or more openings are formed in the dielectric material that is isolating the mesa structures on the lateral sides thereof, and a bottom portion of the mesa structure and/or a portion of the dielectric material in a region directly adjacent to said bottom portion of the mesa structure is removed relative to the substrate and relative to said active layers. A cavity is thereby formed that is subsequently filled with a highly thermally conductive material, thereby creating a volume of high thermal conductivity configured to remove heat from the device to the substrate. In the context of the present invention, the term 'high thermal conductivity' refers to materials having thermal conductivity between 50 and 500 W/mK. Preferred materials are metals such as tungsten or ruthenium.

The method enables improved heat removal from the active device layers while producing the device in a monolithic approach on a substrate, i.e. without requiring substrate transfer steps during the production process of the device. This is especially beneficial in the case of high-power devices such as heterojunction bipolar transistors and high electron mobility transistors comprising active layers formed of III-V materials.

In particular embodiments, the bottom portion of the mesa structure may include a buffer layer of a III-V device processed on a substrate that is lattice mismatched with respect to the III-V material, or a bottom portion of a device processed from a nanoridge structure.

Throughout this description, the expression removing a first layer or material by etching relative to a second layer or material' includes two variants. Firstly the expression can refer to applying a selective etch recipe, i.e. wherein the first material is fully removed while the second material is not removed or removed partially in accordance with an etch selectivity rate (e.g. 95%). Secondly, the expression can refer to removing the first material while the second material is protected by an etch stop layer, i.e. etching stops on the etch stop layer. The etch stop layer may thereafter be removed selectively with respect to the second material by another etch recipe or it may remain in place.

The invention is in particular related to a semiconductor processing method comprising the steps of:
- providing a substrate formed of a first semiconductor material,
- producing a mesa structure on the substrate and in direct contact with the substrate, said mesa structure being isolated on all lateral sides by dielectric material, and wherein active layers of a semiconductor device are integrated in an upper portion of the mesa structure (`upper portion' meaning : lying on the opposite side of the substrate),
- producing one or more openings through said dielectric material. The openings are made only through the dielectric material, i.e. without passing through said active layers,
- removing a bottom portion of the mesa structure through said one or more openings and/or removing said dielectric material in a region directly adjacent said bottom portion of the mesa structure, by one or more etching steps configured to remove material relative to the substrate and relative to said active layers integrated in the upper portion, thereby forming a cavity,
- filling said cavity through said one or more openings with a material of high thermal conductivity, thereby obtaining a thermally conductive volume configured to remove heat produced in one or more of the active layers of the device, towards the substrate.

According to an embodiment, the mesa structure is formed of semiconductor materials which exhibit a lattice mismatch relative to said first semiconductor material.

According to an embodiment, said semiconductor materials exhibiting a mismatch are III-V semiconductor materials.

According to an embodiment, the first semiconductor material is crystalline silicon. Other choices for the first semiconductor material are also possible, for example GaAs.

According to an embodiment, said bottom portion of the mesa structure comprises at least part of a buffer layer formed on the substrate for compensating a lattice mismatch between the first semiconductor material and one or more semiconductor materials applied in the active device layers.

According to an embodiment, the dielectric material is realised in the form of a first dielectric-filled trench that surrounds the mesa structure on all lateral sides and a second dielectric-filled trench of lower depth than the first trench and positioned inside the first trench.

According to an embodiment, producing the mesa structure comprises forming a nanoridge structure extending in a longitudinal direction and forming a first layer obtained by epitaxial growth of a second semiconductor material in a first trench extending in said longitudinal direction and passing through a dielectric support layer formed on the substrate, and subsequently in a second trench wider than the first trench and aligned thereto, the second trench passing through a dielectric template layer formed on the support layer, wherein :
- the second semiconductor material is lattice mismatched relative to the first semiconductor material,
- when growing above the first trench, the first layer expands to the width of the second trench,
- the aspect ratio of the first trench is configured so that the material growing above the first trench is essentially defect-free,
- further semiconductor layers may be grown on the first layer to thereby form the nanoridge structure,
- the production of the mesa structure includes isolating a longitudinally arranged portion of the nanoridge structure so that the mesa structure comprises a portion of the first layer at the bottom of the mesa structure,
- in the longitudinal direction, the mesa structure is isolated on both sides by an additional dielectric layer, and in the direction perpendicular thereto the mesa structure is isolated on both sides by the support layer, the template layer and said additional dielectric layer, so that said dielectric material isolating the mesa structure on all sides includes the materials of the additional dielectric layer, the support layer and the template layer,
- said bottom portion of the mesa structure comprises at least said portion of the first layer at the bottom of said mesa structure.
According to an embodiment, said one or more openings are produced on one or both sides of the mesa structure along said longitudinal direction, said one or more openings passing through the additional dielectric layer.

According to an embodiment, an etch stop layer is produced on the sidewalls of the second trench in the template layer, wherein said bottom portion of the mesa-structure is removed and wherein in addition to the removal of said bottom portion of the mesa-structure, portions of the support layer on both sides of the first trench are removed by etching while the etch stop layer protects the material of the template layer, thereby widening the cavity at the base thereof.

According to an embodiment, said one or more openings are produced on one side of the mesa structure in a direction perpendicular to said longitudinal direction, said one or more openings passing through the additional dielectric layer and at least partially through the template layer and wherein said etching steps include at least etching the material of the template layer and the support layer selectively with respect to the additional dielectric layer and with respect to the substrate.

According to an embodiment, the mesa structure is one of a pair of adjacent mesa structures produced from a pair of mutually parallel nanoridges, wherein the one or more openings are made in the spacing between said mesa structures, and wherein said cavity is common to both mesa structures.

According to an embodiment, one opening is formed between the mesa structures, wherein the width of said opening is aligned to the spacing between the mesa structures.

According to an embodiment, the semiconductor device is a heterojunction bipolar transistor (HBT) or a high electron mobility transistor (HEMT).

The invention is equally related to a semiconductor component comprising a semiconductor substrate, a front end of line portion comprising active semiconductor devices on the substrate, and a back end of line portion on the FEOL portion, wherein at least one of said semiconductor devices comprises active layers which are integrated in an upper portion of a mesa structure that is in direct contact with the substrate, said mesa structure being isolated on all lateral sides by dielectric material, characterized in that the mesa structure comprises a thermally conductive volume extending at least partially between the active layers and the substrate or adjacent to a bottom portion of the mesa structure.

According to an embodiment of the component of the invention, said at least one semiconductor device is a heterojunction bipolar transistor (HBT) or a high electron mobility transistor (HEMT).

### Brief description of the figures

Figures 1 to 5 illustrate an embodiment of the method of the invention applied to a HEMT device.
Figures 6 to 9 illustrate an embodiment of the method of the invention applied to a HBT device produced on a nanoridge structure.
Figures 10 and 11 illustrate a variant of the method of Figures 6 to 9.
Figures 12 to 21 illustrate an embodiment of the method of the invention, applied to a pair of adjacent HBT fingers produced on adjacent nanoridge structures.
Figures 22 and 23 illustrate variants of the invention when applied on a pair of nanoridge based HBT fingers or on a single nanoridge based HBT device.
Figures 24 to 26 illustrate an alternative method according to the invention.

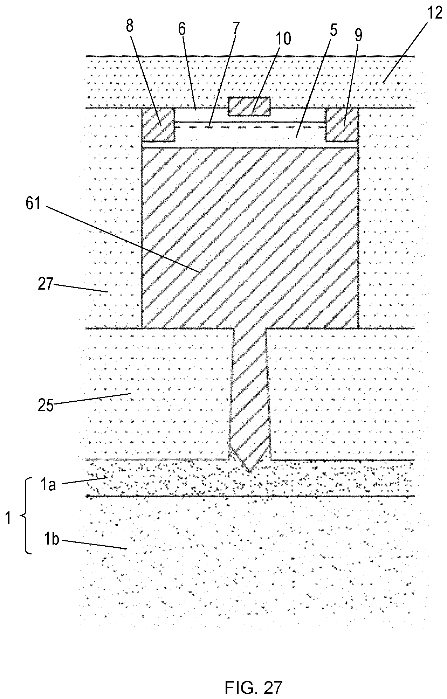

Figure 27 illustrates an embodiment of the invention applied to a nanoridge based HEMT device.

### Detailed description of the invention

In the following detailed description, a number of embodiments of the method of the invention will be described. All references to specific materials and dimensions are cited only by way of example and are not limiting the scope of the present invention.

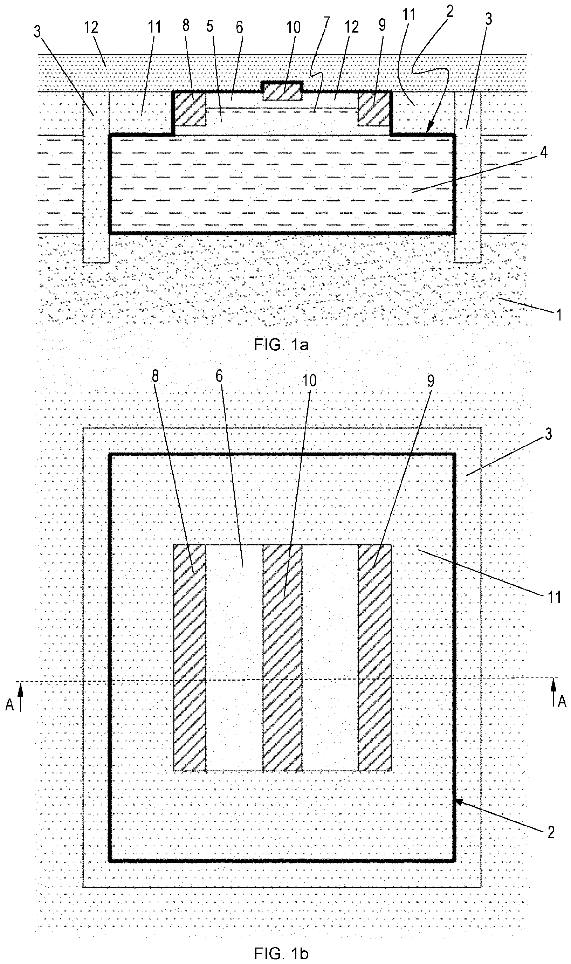

Figures 1a and 1b show two section views of a III-V HEMT device processed on a silicon substrate 1, for example on a 300 mm crystalline silicon process wafer 1. The image is not a drawing on scale of a realistic device, and is intended only to indicate a number of layers and components which are of relevance to the invention. The HEMT is part of a mesa-structure 2 indicated by the bold line in the section views in Figures 1a and 1b. The mesa-structure 2 is isolated on all sides from the remainder of the Si wafer by a deep trench 3 filled with a dielectric material, and by a shallow trench 11 lying inside the deep trench 3 and equally filled with a dielectric material. The bottom portion of the mesa-structure 2 is a thick buffer layer 4 in direct contact with the wafer 1. On the buffer layer 4, active layers of the HEMT are formed, namely a channel layer 5 and a barrier layer 6. The active layers are formed of III-V compound semiconductor materials.

A well-known combination is a GaAs channel layer 5 with a doped AlGaAs barrier layer 6 on top. The doping level of the barrier layer is configured to create a so-called 2DEG (2-dimensional electron gas) 7 in the channel layer 5, at the interface between the channel layer 5 and the barrier layer 6, exhibiting high electron mobility in the plane of the 2DEG. Source and drain electrodes 8 and 9 are in electrical contact with the 2DEG 7, and a gate electrode 10 is produced between the source and drain electrodes. Further examples of III-As based HEMTs in terms of the materials of the barrier and channel layers can be, AlGaAs/InGaAs, InGaP/InGaAs, InAlAs/InGaAs, InAlAs/InP. The shallow and deep dielectric-filled trenches 11 and 3 isolate the HEMT from other devices processed on the wafer 1. The dielectric material in said trenches may be SiO₂ for example. On top of the mesa structure 2 is a layer 12 of dielectric material which may be referred to as a pre-metal dielectric. It may be SiO₂ or a low k material. Layer 12 is transparent in the plane view in Figure 1b in order to visualize the various components.

The main purpose of the buffer layer 4 is to alleviate the effects of the mismatch between the lattice constants of the substrate 1 and the active layers of the transistor. The buffer layer 4 is thick, for example in the order of 1 to 10 µm, compared to the active device layers 5,6 which are usually in the order of tens of nanometres in thickness. The buffer layer 4 is often produced from alloy materials which have low thermal conductivity. For III-As based HEMTs, the buffer can be formed of GaAs, InP, AlAs or their alloys such as InGaAs, InAlAs, InGaP etc. as well known in the art.

Many ways exist of bringing the mesa structure 2 into practice, in terms of the materials chosen, thicknesses of the various layers and geometrical configuration of the electrodes. Methods for producing a HEMT according to any of these known configurations are well-known and are therefore not included in this description. The invention deals with a number of additional steps aimed at lowering the thermal resistance (improving the heat removal) from the device to the substrate. These steps are performed before via connections are produced through the pre-metal dielectric layer 12 for connecting the electrodes of the HEMT to electrical conductors embedded in further dielectric layers of a back end of line (BEOL) interconnect structure that is built layer by layer on top of the front end of line (FEOL) layer which comprises the HEMT and other devices processed on the Si wafer 1.

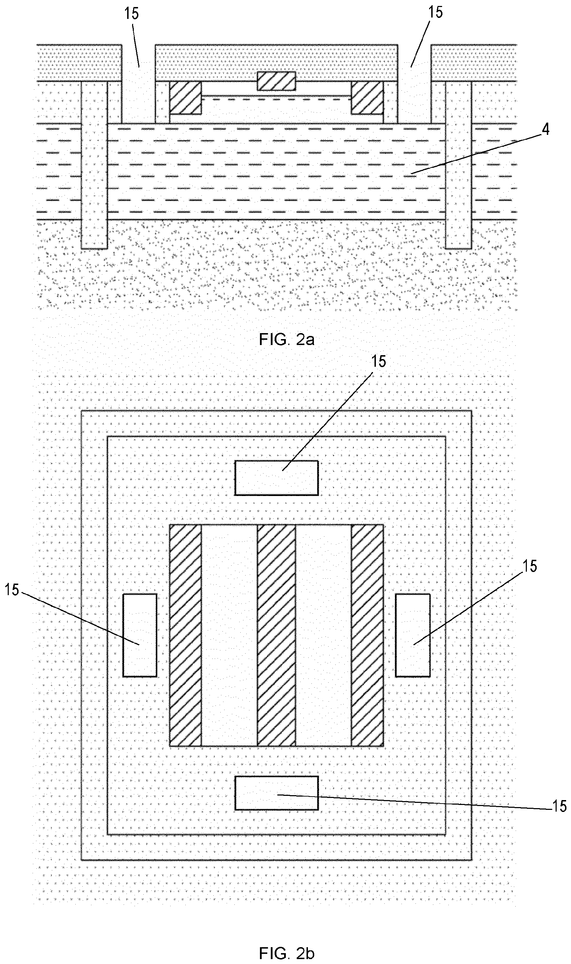

As illustrated in Figures 2a and 2b, via openings 15 are produced through the pre-metal dielectric layer 12 and the STI region 11. This may be done by standard lithography and etch steps. The etch process stops on the buffer layer 4 but may also continue to some degree into the buffer layer.

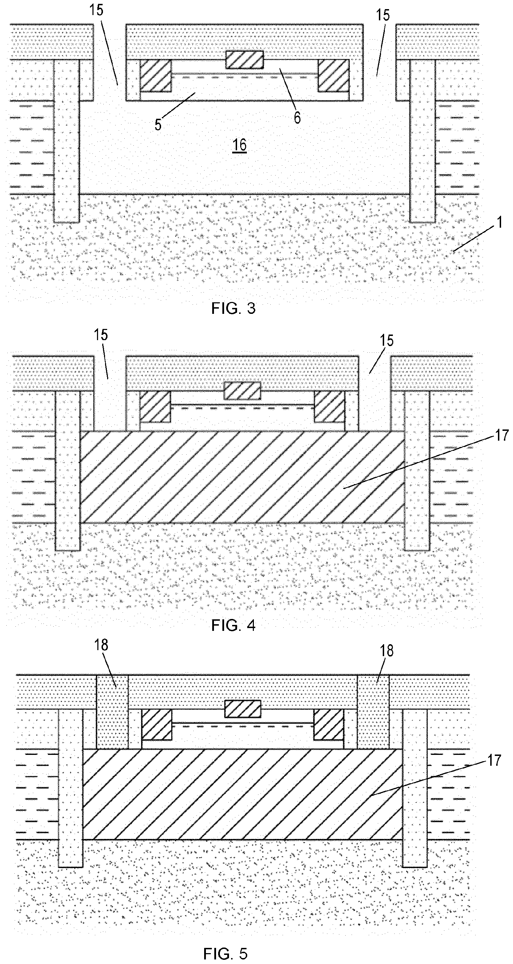

Following this and as illustrated in Figure 3, the buffer layer 4 is removed relative to the Si wafer 1, the dielectric material in the deep trenches 3 and in the shallow trenches 11, and with respect to the active layers of the HEMT. This may be done by applying one or more wet etch recipes. The etchant dissolves the buffer layer materials which are then removed through the via openings 15. Suitable selective etch recipes are known in the art for the selective removal of at least the above-named materials which are currently known to be applied as constituent materials of a buffer layer used in HEMT designs, wherein the etch recipes are selective with respect to the substrate 1 and with respect to the dielectric materials in the trenches 3 and 11. It may be required to include an etch stop layer between the buffer layer and the channel layer, to avoid removing the channel layer fully or partially.

The etch process creates a cavity 16 located directly adjacent the wafer 1 and between the HEMT device and the wafer 1. This cavity 16 is subsequently filled with a highly thermally conductive material through the openings 15, which may for example be done by ALD or CVD (Chemical Vapor Deposition). The highly thermally conductive material is preferably a metal, for example copper, tungsten or ruthenium. This step may be preceded by producing a metal seed layer on at least part of the inner surface of the cavity 16.

The metal filling process ends when the cavity 16 is filled with metal, as illustrated in Figure 4, thereby obtaining a volume 17 of high thermal conductivity. In the embodiment shown, no metal is formed in the via openings 15.

The next step is illustrated in Figure 5 and consists of filling the via openings 15 with a dielectric 18, preferably this is the same material as the pre-metal dielectric layer 12. The upper surface is then planarized, resulting in the image shown in Figure 5. From this point on, known steps may be performed for producing via connections to the electrodes of the HEMT and for producing the multiple layers forming the BEOL structure.

According to another embodiment, the metal filling process continues to fill the openings 15 with metal. These metal-filled openings may be used as conductors for realizing an electrical connection to the volume 17, so that this volume is not in an electrically floating state during operation of the HEMT.

The metal-filled cavity 17 represents a volume having high thermal conductivity that extends between the substrate 1 and the active layers 5,6 of the HEMT and will thus be able to efficiently evacuate heat produced by the HEMT towards the wafer 1 when said HEMT is in operation.

It is a characteristic of all embodiments of the invention that the highly thermally conductive volume is obtained in a so-called monolithic production process, i.e. a production process of semiconductor components such as IC chips on a substrate, wherein the substrate 1 remains the supporting member of the multiple active devices of the component throughout the FEOL and BEOL stages of the production process. This means that no transfer of fully or partially processed active devices to another substrate takes place during the production process.

The requirements of the material used for filling the cavity 16 is that it is highly thermally conductive so as to enhance heat removal from the semiconductor device. Metals are therefore prime candidates for this material.

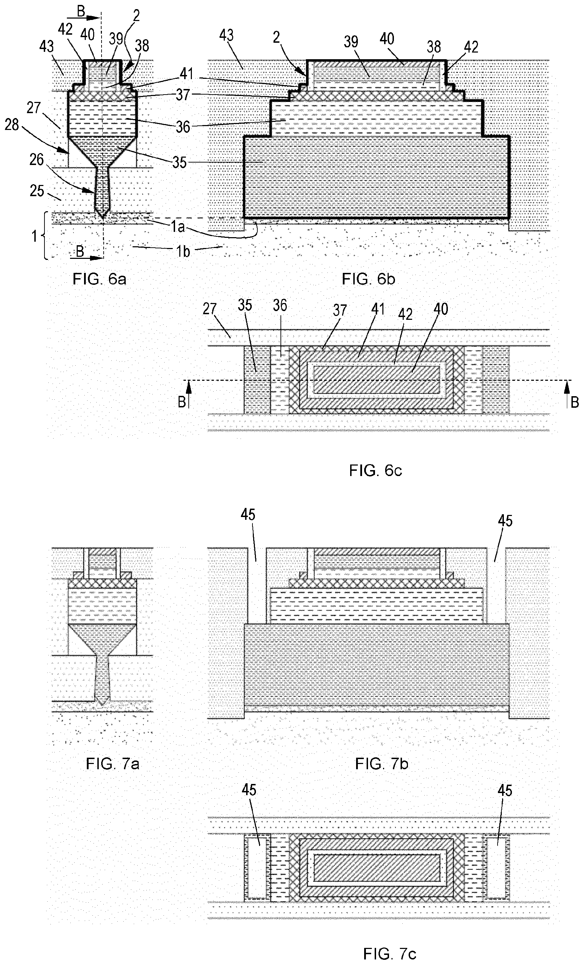

Another device to which the invention is applicable is shown in Figures 6a to 6c, showing views in three orthogonal directions of a heterojunction bipolar transistor (HBT) produced on a nanoridge structure. Nanoridge engineering (NRE) technology is known as such and described for example in patent publication document EP3789519. According to known embodiments, the technique involves the growing of III-V material in narrow nano-sized grooves having silicon or another material that is lattice mismatched with respect to the III-V material at the bottom of the grooves. The material grows into nano-ridges which protrude out of the grooves. Defects are trapped in the grooves by aspect ratio trapping (ART), and the upper layers of the nano-ridges are essentially defect-free. NRE thereby enables the growth of III-V materials on lattice mismatched substrates without requiring a thick buffer layer.

Figures 6a to 6c illustrate the HBT in two orthogonal section views and a plane view. The substrate 1 is a Si process wafer. For producing HBTs or HEMTs for RF applications, a nominal resistivity or high resistivity (> 100 Ω.cm) Si wafer is preferably used. As seen in Figure 6a, a dielectric layer 25 lies directly on the wafer surface, and a narrow trench 26 cuts through the dielectric layer 25. The bottom of the trench is Si that has been anisotropically etched, i.e. according to the crystal planes of the crystalline Si, resulting in a V-shaped bottom shape. This can be done by producing a narrow Si fin, thereafter depositing the dielectric layer 25, planarizing the latter, and selectively etching the material of the fin by anisotropic etching.

According to the illustrated embodiment, the Si fin is initially produced in a top layer 1a of the substrate. In the exemplary case described hereafter of an npn HBT produced on Si, the top layer 1a is n-doped and obtained by a doping implant on a p-Si process wafer 1a. The n-doping is used to create a p-n junction for low leakage from the HBT to the substrate. The invention is however not limited to the use of Si substrates. Other substrates may be used, such as Ge, GaAs or InP substrates.

A second dielectric layer 27 is produced on the planarized surface, and a second trench 28 is produced therein, aligned to and preferably coaxial with the narrow trench 26, and significantly wider than the narrow trench 26. The second dielectric layer 27 is hereafter referred to as a template layer, while the first dielectric layer 25 is hereafter referred to as a support layer.

III-V material 35 is then grown by epitaxial growth in the narrow trench 26, which may be done by metal organic vapour phase epitaxy (MOVPE) in a reactor suitable for applying this growth technique. The III-V material exhibits a lattice mismatch with respect to the Si lattice. The width and depth of the narrow trench 26 are however chosen such that growth defects are trapped in said trench 26, and the material growing out of the trench 26 is essentially defect-free. Once the material reaches the top of the narrow trench 26, it expands to a width higher than the narrow trench width, until the widening is stopped by the sidewalls of the wider trench 28 in the template layer 27. III-V material grown directly on the Si wafer is therefore essentially defect-free at its upper surface, where it has the width of the template trench 28, which may be in the order of 1 micrometre for example.

An HBT as illustrated in Figures 6a-6c is produced from a nano-ridge structure which may be several millimetres long, and which is formed by growing further III-V layers on the layer that is grown directly on the Si and that widens to the width of the wide trench 28. A number of the upper layers are then processed by known method steps to arrive at the HBT structure as illustrated. The resulting HBT is again part of a mesa-structure 2 delineated by the thick line in Figures 6a and 6b.

The exemplary device shown is an npn HBT comprising the following parts : a subcollector 35, a collector 36, a base 37, an emitter 38, an emitter contact layer 39, an emitter electrode 40, a base electrode 41. The subcollector 35 and the emitter contact layer 39 are high n-doped regions. The collector 36 and the emitter 38 are low n-doped regions. The base 37 is high p-doped. The electrodes are formed of metal. The terms 'high or low doped' refer to higher or lower doping levels of a given layer. As known in the art, required doping levels may be obtained by adding measured concentrations of dopants to the MOVPE reactor during the growth process.

The subcollector 35 includes the III-V material grown in the narrow trench 26 on the lattice-mismatched Si at the bottom said narrow trench. The part of subcollector 35 which grows inside the trench 26 may therefore be regarded in the present context as a buffer layer as it fulfils the function of compensating said lattice mismatch, even though this is achieved in a different way than in the case of a blanket buffer layer 4 as described with reference to Figures 1 to 5.

Examples of possibly applicable materials are the following: n-doped InGaAs, InAlAs, InGaP or InP for the subcollector 35, n-doped InP, InGaP, or InAIAs for the collector 36, n-doped InP or InGaP for the emitter 38 and InGaAs or InAs for the emitter contact layer 39, with high or low doping levels according to requirement, and p-doped InGaAs or GaAsSb for the base 37. Suitable doping levels and thicknesses of the various layers are known in the art.

The emitter 38 and emitter contact layer 39 are laterally isolated from the base electrode 41 by a dielectric spacer 42. Along the length direction of the nano-ridge (as seen in Figure 6b), the subcollector 35 is longer than the collector 36, and said collector 36 is longer than the base 37, which is in turn longer than the emitter/emitter contact stack 38/39. The mesa structure 2 is isolated from other devices lying in the longitudinal direction of the nanoridge by an additional dielectric layer 43, that is planarized to a common level with the upper surface of the emitter electrode 40.

The 'additional dielectric layer' 43 is represented as a uniform layer but it may consist of different parts and materials. For example it may include a deep trench like the trench 3 shown in Figure 1a around a group of adjacent HBT fingers (see further), and it may further comprise pre-metal dielectric material deposited on the active layers of the HBT device and planarized in preparation of the further processing of the BEOL portion.

In the direction perpendicular thereto, the mesa structure 2 is isolated by said same dielectric layer 43, and further by the opposite portions of the template layer 27 on either side of the wide trench 28 produced in said template layer, and by the opposite portions of the support layer 25 on either side of the narrow trench 26 in the support layer 25. The support layer 25 and the template layer 27 can be SiO₂. The dielectric layer 43 may be comprise SiO₂ or a low k dielectric layer. In the plane view in Figure 6c, the dielectric layer 43 is transparent in order to visualize the underlying parts.

According to the embodiment shown in the drawings, the subcollector 35 is a portion of the first layer of the nanoridge, i.e. the layer that is grown directly on the Si at the bottom of the narrow trench 26 and that grows out of the narrow trench to the width of the wider trench 28. Said portion is isolated on both sides by the dielectric layer 43. According to other embodiments, the subcollector 35 could comprise one or more additional layers on said portion of the directly grown nanoridge layer.

According to the prior art, the stage shown in Figures 6a-6c is followed by the production of a further pre-metal dielectric on the planarized upper surface, and by etching via openings through the pre-metal dielectric towards the subcollector 35, the base 37 and emitter contact layer 39, and filling these openings with metal for connecting these parts of the HBT to the BEOL portion that is thereafter built layer by layer on said planarized surface.

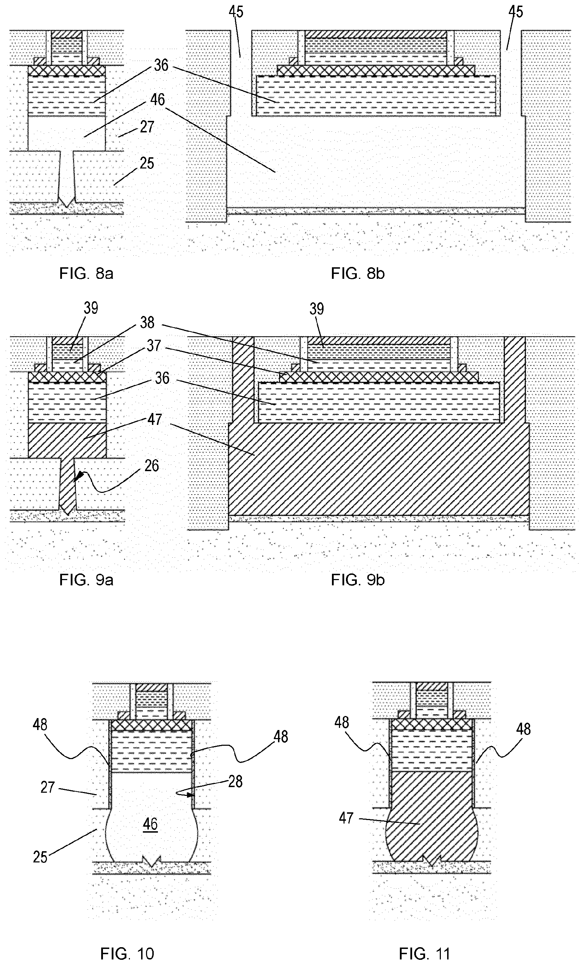

According to this embodiment of the invention, a number of additional steps is performed prior to making these electrical connections and building the BEOL portion. A first nanoridge-based embodiment is illustrated in Figures 7 to 10. As shown in Figures 7a to 7c, via openings 45 are produced through the dielectric layer 43, on both sides of the collector 36, landing on the subcollector 35. Reference is then made to Figures 8a and 8b. A wet etchant is supplied through the via openings 45, and the subcollector 35 is removed relative to the collector 36 and relative to the dielectric material of the support layer 25 and the template layer 27. Etch recipes with sufficient selectivity are available for removing most III-V materials relative to dielectric materials and to other III-V material, for example for removing InP relative to SiO₂ and vice-versa. When the material of the subcollector 35 is different from the material of the collector 36, a selective etch recipe can be used to remove the subcollector 35 relative to the collector 36. Often however, the same material is used for the collector and the subcollector. In this case, an etch stop layer may be applied as the top layer of the subcollector 35. For example, the subcollector 35 may comprise a bottom portion directly on the Si in the narrow trench 26 and widening to the width of the wide trench 28, and on said bottom portion, the subcollector 35 may further comprise an additional thin layer of III-V material of a different type than the material of said bottom portion. For example, a thin highly n-doped InGaAs layer could be grown on the highly n-doped InP bottom part during the production of the nanoridge structure. This thin layer stops the wet etch process when the InP bottom portion of the subcollector is removed. In another example, the subcollector 35 consists of InGaAs grown on Si and the collector 36 consists of InP, InGaP, or InAlAs and the InGaAs of the subcollector 35 is selectively etched with respect to the collector materials. After the removal of the subcollector 35 (possibly with the exception of a thin etch stop layer in some cases), a cavity 46 is created underneath the HBT, as shown in Figures 8a and 8b.

This is then followed by depositing a highly thermally conductive material, in the cavity 46, which can be done by ALD or CVD. In this case, the material must also be electrically conductive, so it is preferably a metal like but not limited to copper, tungsten or ruthenium. This may be preceded by the formation of a metal seed layer on the inner surface of the cavity 46. As shown in Figures 9a and 9b, a volume 47 of high thermal conductivity is thereby obtained. In the case shown, the metal also fills the via openings 45, so that when the upper surface is planarized as shown, the BEOL part can be produced thereon, including electrical connections to the collector, base and emitter of the HBT. The metal volume 47 thereby also plays the part of contact electrode to the collector 36.

The metal-filled cavity 47 again represents a volume having high thermal conductivity towards the substrate 1, enabling more efficient heat removal from the HBT when the latter is operational in a component comprising the HBT and other devices produced on the substrate 1 by a monolithic process. However, the narrow metal-filled trench 26 may still geometrically constrict the heat flow to some degree. A more advantageous embodiment is illustrated in Figures 10 and 11. An etch stop layer 48 has been provided on the sidewalls of the wider trench 28 in the template layer 27. This may for example be a thin SiN layer. The presence of this etch stop layer 48 allows to remove also a portion of the support layer 25 without attacking the template layer 27, so that the cavity 46 is wider at the base compared to the case shown in Figure 8a. Filling the cavity with metal, as shown in Figure 11, this results in a larger metal volume 47 and hence to a better thermal conductivity.

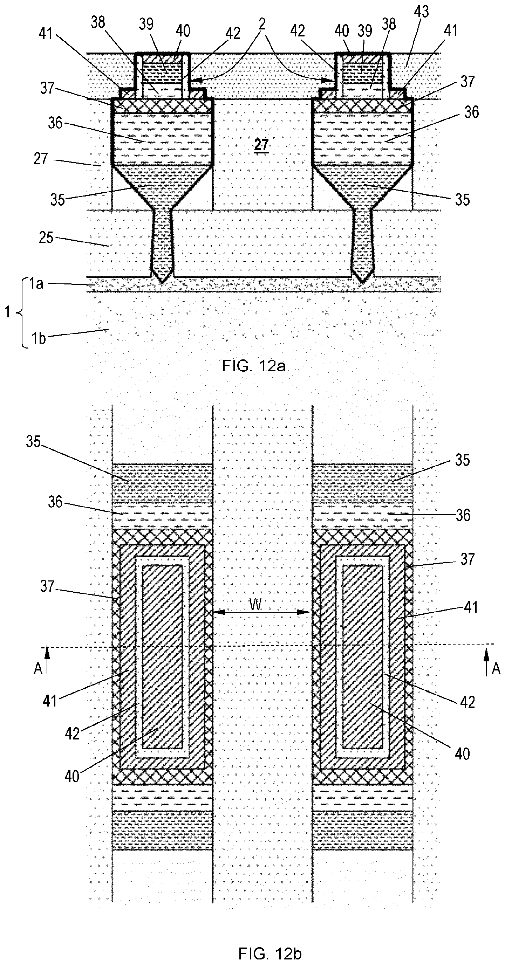

Another embodiment is illustrated in Figures 12 to 21. Figures 12a and 12b show two HBT structures produced side by side on two adjacent nanoridge structures and intended to form together a single HBT by interconnecting the respective electrodes. For this reason, the adjacent structures are hereafter referred to as HBT fingers . Nanoridge structures are usually produced in large numbers of mutually parallel structures, to enable processing multi-finger devices thereon. This embodiment of the invention makes use of the spacing between two adjacent nanoridges to realise a highly thermally conductive volume underneath the two adjacent fingers. The width W of the spacing may be in the same order of magnitude as the width of the nanoridges. The same numerical references are applied for indicating the constituent parts of the adjacent HBTs, each of which is part of a mesa structure 2 as defined above.

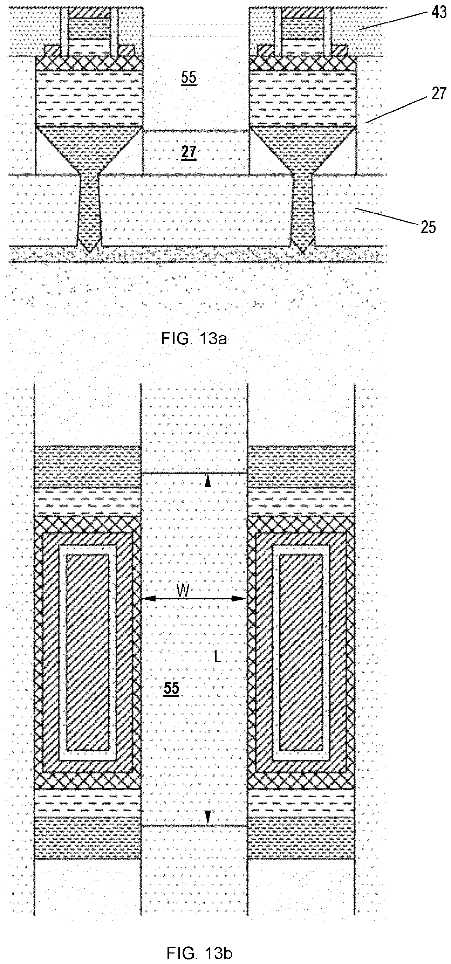

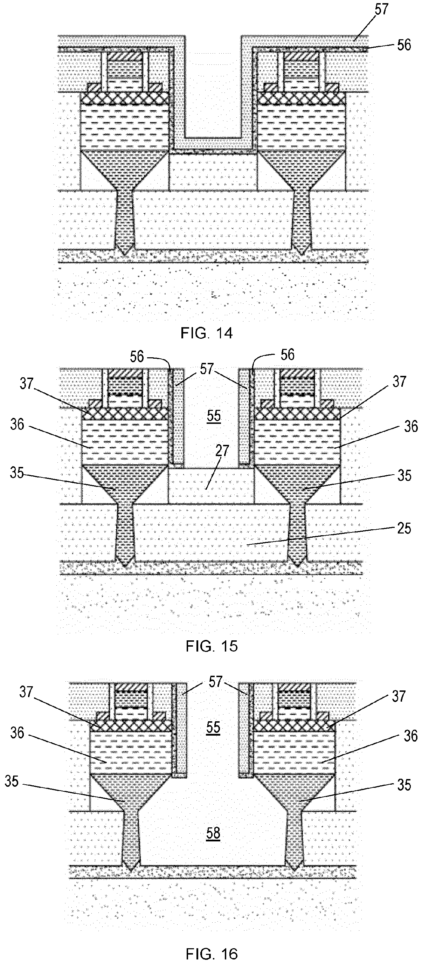

As illustrated in Figures 13a and 13b, an opening 55 is etched through the dielectric layer 43 and partially through the template layer 27. The opening 55 is aligned to the spacing between the HBT fingers, i.e. said opening has the same width W as the spacing. The length L of the opening 55 is of the same order of magnitude as the length of the mesa structures 2. With reference to Figure 14, an etch stop layer 56 and a further dielectric layer 57 are produced conformally on the sidewalls and the bottom of the opening 55, and on the upper planarized surface of the dielectric layer 43. The etch stop layer 56 could be formed for example of HfO₂ or Al₂O₃ and may be applied by ALD. The material of dielectric layer 57 is chosen so that the material of the template layer 27 and the support layer 25 can be removed with high selectivity by wet etching, relative to this layer 57. A dry etch process is then applied, removing the dielectric layer 57 on the horizontal parts and maintaining it on the sidewalls of the opening 55. This dry etch process is stopped by the etch stop layer 56, which is thereafter removed as shown in Figure 15, by another dry etch recipe that removes the etch stop layer 56 selectively with respect to the underlying materials. In an alternative approach, the etch stop layer 56 is not applied, and the dry etch for removing layer 57 on the horizontal parts is a timed etch process.

Thereafter, the material of the template layer 27 and of the support layer 25 is removed in the area exposed by the opening 55, said area lying between the subcollectors 35 of the HBTs. In the length direction of the nanoridges, said area is delimited by delimiting regions formed of the dielectric material of layer 43. In these delimiting regions in the longitudinal direction of the HBT fingers, said dielectric material must therefore be chosen so that the template and support layer materials are removable selectively with respect to said dielectric material of layer 43. One example of a suitable material is Si₃N₄. The removal of these materials creates a cavity 58 as illustrated in Figure 16, while the collectors 36 and bases 37 of the HBTs are protected by the dielectric layer 57 on the sidewalls of the opening 55.

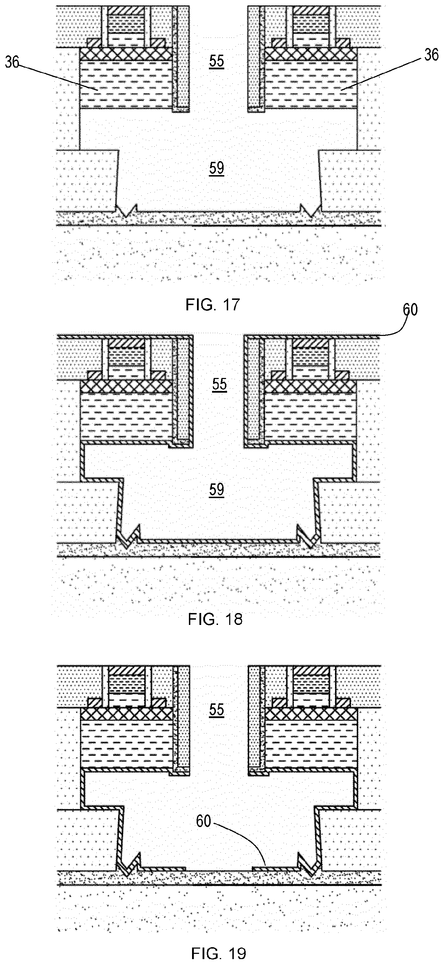

With reference to Figure 17, another wet etch recipe is applied which removes the subcollector layers 35 of both HBTs relative to the respective collectors 36 thereof. Depending on the materials used for the various layers, it may be required to provide an etch stop layer as the top layer of the subcollectors 35, as described above, in order to ensure that the collectors 36 are not attacked by this etch process. An enlarged cavity 59 is thereby obtained.

The next step may be applied also in the embodiments described previously, but here it is shown explicitly in Figure 18. A metal seed layer 60 is deposited conformally on the exposed inner surface of the enlarged cavity 59 and on the upper planarized surface of the dielectric layer 43. This may be done by ALD. The metal seed layer 60 is suitable for depositing thereon a metal by ALD or CVD

As shown in Figure 19, an anisotropic etch process with some degree of lateral etching may be applied, removing the seed layer 60 in areas which are visible in the direction perpendicular to the upper planarized surface. This removes the seed layer 60 from said upper surface, from the sidewalls of the opening 55 and from a central area of the bottom of the enlarged cavity 59.

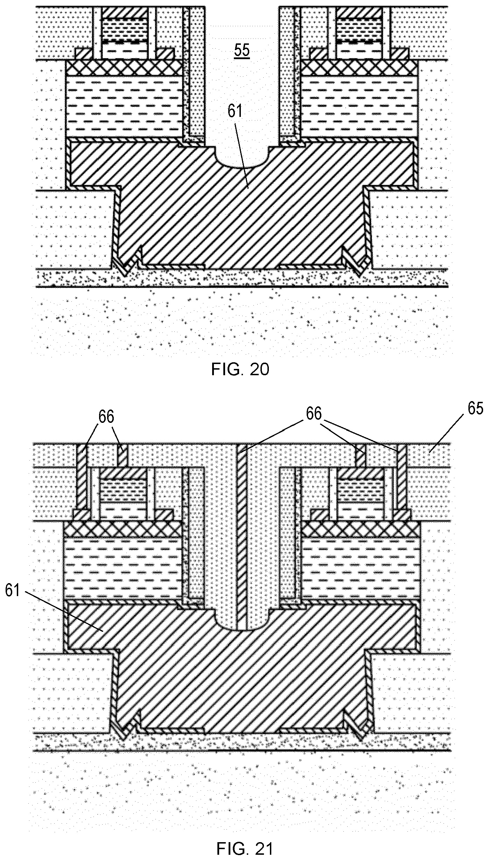

Thereafter and with reference to Figure 20, a metal is deposited by selective ALD or CVD (for example tungsten CVD), so that it grows isotropically starting from the exposed seed layer portions. This results in a thermally and electrically conductive metal volume 61 as shown in Figure 20 if the ALD or CVD is stopped before metal can further build up in the opening 55. Such a metal buildup is however allowable as well, up to a point where the opening 55 is completely or partially filled with metal. The volume 61 is located underneath both HBT fingers and bridges also the spacing between said HBT fingers. As in the other embodiments, the volume 61 enables improved heat removal from the HBT fingers compared to existing designs.

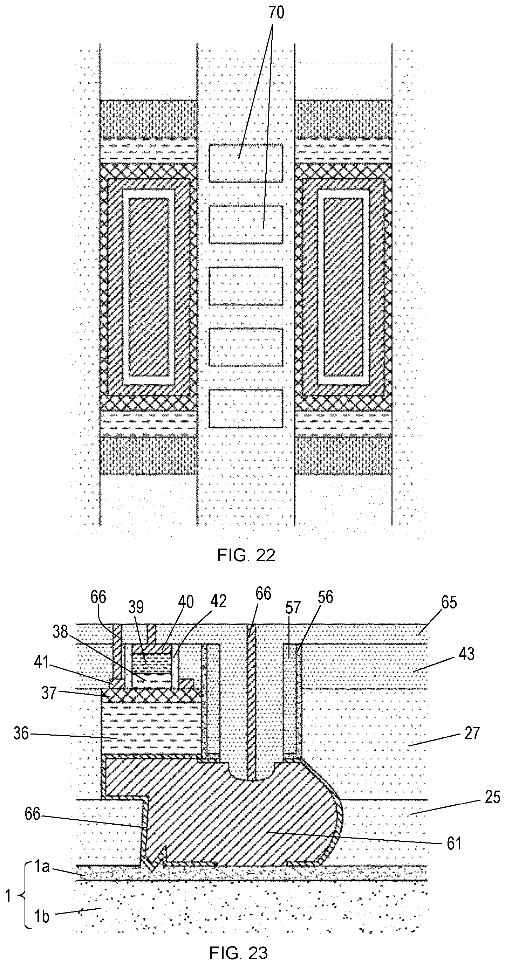

The stage shown in Figure 20 may be followed as shown in Figure 21 by depositing a pre-metal dielectric layer 65 and producing interconnect vias 66 through said layer, for contacting the emitter and base electrodes of the HBTs, and for contacting the metal volume 61, which acts as a common collector electrode for the HBTs. Alternatives to some of the above-described method steps are possible within the scope of the invention. For example, instead of producing an opening 55 that is aligned to the spacing between the HBTs, multiple smaller openings 70 can be produced in said spacing area, as illustrated in Figure 22. Like the larger opening 55, these openings 70 pass through the dielectric layer 43 and partially into the template layer 27. The removal of the template layer and support layer portions between the subcollectors 35 and of the subcollectors 35 themselves (or at least a bottom portion thereof) then takes place through these openings 70. Also the deposition of the metal seed layer 60 and of the metal filling takes place through these openings 70. This embodiment does not require protecting the collectors and bases of the HBT fingers during the wet etch process.

Another embodiment is illustrated in Figure 23, which shows the result of the method explained above for the case of two adjacent HBT fingers, but applied to a single finger HBT. The opening 55 is produced adjacent the HBT. The wet etching step removes part of the template layer 27 and the support layer 25, as well as the subcollector 35. The etch stop layer 56 and dielectric layer 57 are applied and have the same function as explained above. Material of the template and support layers is partially removed also in the direction away from the HBT location, resulting in a metal-filled cavity 61 that is partially located under the HBT, as shown in the drawing.

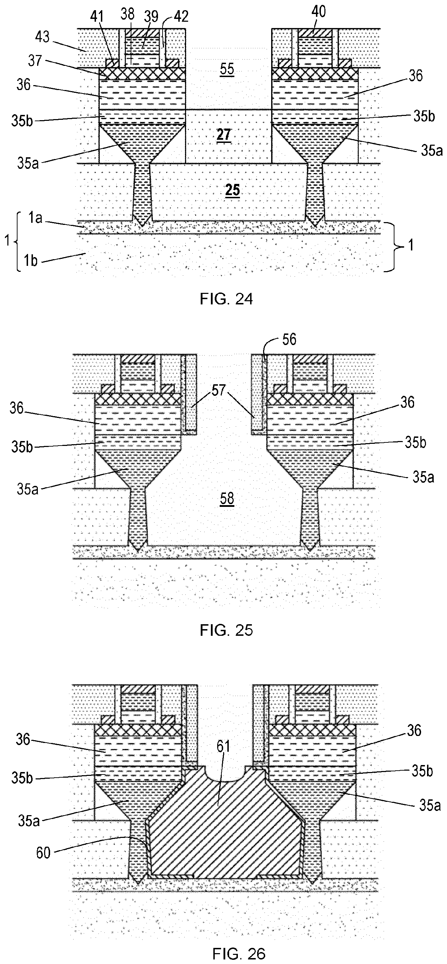

A further alternative is illustrated in Figures 24 to 26. In Figure 24 it is seen that the HBT fingers have a slightly different structure compared to the embodiment of Figures 12-20. The subcollector now comprises a bottom part 35a and at top part 35b. According to an example, the bottom part 35a is formed of the poorly thermally conductive InGaAs and the top part is formed of the more thermally conductive InP. As seen also in Figure 24, the opening 55 is produced to a lower depth compared to the embodiment of Figures 12-20 : the bottom of the opening is more or less at the same level as the interface between the top subcollector part 35b and the collector 36. After this, the etch stop layer 56 and dielectric layer 57 are applied and the material of the template layer 27 and the support layer 25 is removed through the opening 55, resulting in the structure shown in Figure 25, i.e. the creation of the cavity 58. At this point, rather than enlarging the cavity 58 by removing the subcollectors 35, the metal fill step, including deposition and patterning of the metal seed layer 60 is performed in the cavity 58, as illustrated in Figure 26. The metal volume 61 is now in direct contact with the thermally conductive top part 35b of the subcollectors, and is thereby able to remove heat produced by the active layers of the HBT fingers. According to this embodiment therefore, a bottom portion of the mesa structure 2 is not removed and replaced with a highly thermally conductive material, but such a material is formed in a region directly adjacent said bottom portion. As illustrated, the method according to this embodiment is preferably configured so that the highly thermally conductive volume 61 is formed adjacent a thermally conductive part of the mesa structure.

Therefore, according to the method of the invention, to create the cavity that is to be filled with highly thermally conductive material, either a bottom portion of the mesa structure is removed (as in Figures 3 and 8a/8b), or said bottom portion is removed together with a portion of dielectric material in a region directly adjacent said bottom portion (as in Figures 17 and 23), or only said portion of dielectric material in a region directly adjacent to the bottom portion of the mesa structure is removed (as in Figure 24). In every one of these three embodiments, the highly thermally conductive volume obtained by filling the cavity enhances considerably the heat transfer from the device comprising active layers in the upper portion of the mesa structure, to the substrate onto which said mesa structure has been processed.

It is also possible to produce a HEMT on a nanoridge structure and provide the HEMT with a highly thermally conductive volume 61 in accordance with the invention, as is illustrated in Figure 24. The active layers and electrodes of the HEMT are numbered by the same reference numerals as in the case of the HEMT shown in Figure 5. The method steps for producing this particular embodiment are the same as described for the HBT shown in Figures 9a and 9b.

The method is applicable to other semiconductor devices besides HBTs and HEMTs, for example PIN diodes and lasers.

The invention is also related to a semiconductor component, for example an IC chip obtainable by applying the method of the invention in the production process of the component on a semiconductor substrate, for producing one or more devices such as HBTs or III-V HEMTs in the FEOL portion of the chip. The component is characterized by the fact that one or more devices have active layers integrated in an isolated mesa structure comprising a highly thermally conductive volume configured to conduct heat from said active layers to the substrate.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A semiconductor processing method comprising the steps of:
- providing a substrate (1) formed of a first semiconductor material,
- producing a mesa structure (2) on the substrate (1) and in direct contact with the substrate (1), said mesa structure being isolated on all lateral sides by dielectric material (3,11;25,27,43), and wherein active layers (5,6;36-39) of a semiconductor device are integrated in an upper portion of the mesa structure (2),
- producing one or more openings (15,45,55,70) through said dielectric material without passing through said active layers,
- removing a bottom portion (4,35) of the mesa structure through said one or more openings and/or removing said dielectric material in a region directly adjacent said bottom portion (35) of the mesa structure, by one or more etching steps configured to remove material relative to the substrate (1) and relative to said active layers integrated in the upper portion, thereby forming a cavity (16,46,58,59)
- filling said cavity through said one or more openings with a material of high thermal conductivity, thereby obtaining a thermally conductive volume (17,47,61) configured to remove heat produced in one or more of the active layers of the device, towards the substrate (1).

2. The method according to claim 1, wherein the mesa structure (2) is formed of semiconductor materials which exhibit a lattice mismatch relative to said first semiconductor material.

3. The method according to claim 2, wherein said semiconductor materials exhibiting a mismatch are III-V semiconductor materials.

4. The method according to claim 2 or 3, wherein the first semiconductor material is crystalline silicon.

5. The method according to any one of the preceding claims, wherein said bottom portion of the mesa structure comprises at least part of a buffer layer (4,35) formed on the substrate for compensating a lattice mismatch between the first semiconductor material and one or more semiconductor materials applied in the active device layers (5,6;36-39).

6. The method according to any one of the preceding claims, wherein the dielectric material is realised in the form of a first dielectric-filled trench (3) that surrounds the mesa structure (2) on all lateral sides and a second dielectric-filled trench (11) of lower depth than the first trench and positioned inside the first trench.

7. The method according to any one of claims 1 to 5, wherein producing the mesa structure (2) comprises forming a nanoridge structure extending in a longitudinal direction and forming a first layer obtained by epitaxial growth of a second semiconductor material in a first trench (26) extending in said longitudinal direction and passing through a dielectric support layer (25) formed on the substrate (1), and subsequently in a second trench (28) wider than the first trench and aligned thereto, the second trench passing through a dielectric template layer (27) formed on the support layer (25), wherein :
- the second semiconductor material is lattice mismatched relative to the first semiconductor material,
- when growing above the first trench (26), the first layer expands to the width of the second trench (28),
- the aspect ratio of the first trench (26) is configured so that the material growing above the first trench is essentially defect-free,
- further semiconductor layers may be grown on the first layer to thereby form the nanoridge structure,
- the production of the mesa structure (2) includes isolating a longitudinally arranged portion of the nanoridge structure so that the mesa structure comprises a portion (35) of the first layer at the bottom of the mesa structure,
- in the longitudinal direction, the mesa structure is isolated on both sides by an additional dielectric layer (43), and in the direction perpendicular thereto the mesa structure is isolated on both sides by the support layer (25), the template layer (27) and said additional dielectric layer (43), so that said dielectric material isolating the mesa structure on all sides includes the materials of the additional dielectric layer (43), the support layer (25) and the template layer (27),
- said bottom portion of the mesa structure (2) comprises at least said portion (35) of the first layer at the bottom of said mesa structure.

8. The method according to claim 7, wherein said one or more openings (45) are produced on one or both sides of the mesa structure (2) along said longitudinal direction, said one or more openings passing through the additional dielectric layer (43).

9. The method according to claim 7 or 8, wherein an etch stop layer (48) is produced on the sidewalls of the second trench (28) in the template layer (27), wherein said bottom portion (35) of the mesa-structure (2) is removed and wherein in addition to the removal of said bottom portion (35) of the mesa-structure (2), portions of the support layer (25) on both sides of the first trench (26) are removed by etching while the etch stop layer (48) protects the material of the template layer (27), thereby widening the cavity (46) at the base thereof.

10. The method according to claim 7, wherein said one or more openings (55,70) are produced on one side of the mesa structure (2) in a direction perpendicular to said longitudinal direction, said one or more openings passing through the additional dielectric layer (43) and at least partially through the template layer (27) and wherein said etching steps include at least etching the material of the template layer (27) and the support layer (25) selectively with respect to the additional dielectric layer (43) and with respect to the substrate (1).

11. The method according to claim 10, wherein the mesa structure (2) is one of a pair of adjacent mesa structures (2) produced from a pair of mutually parallel nanoridges, wherein the one or more openings (55,70) are made in the spacing between said mesa structures (2), and wherein said cavity (61) is common to both mesa structures (2).

12. The method according to claim 11, wherein one opening (55) is formed between the mesa structures (2), wherein the width of said opening (55) is aligned to the spacing between the mesa structures.

13. The method according to any one of the preceding claims, wherein the semiconductor device is a heterojunction bipolar transistor (HBT) or a high electron mobility transistor (HEMT).

14. A semiconductor component comprising a semiconductor substrate (1), a front end of line portion comprising active semiconductor devices on the substrate, and a back end of line portion on the FEOL portion, wherein at least one of said semiconductor devices comprises active layers (5,6;36-39) which are integrated in an upper portion of a mesa structure (2) that is in direct contact with the substrate, said mesa structure being isolated on all lateral sides by dielectric material, **characterized in that** the mesa structure comprises a thermally conductive volume (17,47,61) extending at least partially between the active layers and the substrate (1) or adjacent to a bottom portion (35) of the mesa structure (2).

15. The semiconductor component according to claim 14, wherein said at least one semiconductor device is a heterojunction bipolar transistor (HBT) or a high electron mobility transistor (HEMT).
